# EUROPÄISCHE PATENTSCHRIFT

(11) **EP 3 036 833 B1**
(45) Veröffentlichungstag und Bekanntmachung des Hinweises auf die Patenterteilung: **05.08.2020**
(21) Anmeldenummer: 14750506.9
(22) Anmeldetag: 13.08.2014
(51) Int. Cl.: H03K 17/955

(54) **EINRICHTUNG ZUM BERÜHRUNGSLOSEN BETÄTIGEN EINER FAHRZEUGTÜR**
DEVICE FOR ACTUATING A VEHICLE DOOR IN A CONTACT-FREE MANNER
SYSTÈME D'ACTIONNEMENT SANS CONTACT D'UNE PORTE DE VÉHICULE

(30) Priorität: 23.08.2013 DE 102013014142
(43) Veröffentlichungstag der Anmeldung: 29.06.2016
(73) Patentinhaber: Brose Fahrzeugteile SE & Co. Kommanditgesellschaft, Bamberg, 96052 Bamberg (DE)
(72) Erfinder: STERK, Felix, 88281 Schlier (DE); GEUTHER, Udo, 96049 Bamberg (DE)
(74) Vertreter: FDST Patentanwälte
(86) Internationale Anmeldenummer: PCT/EP2014/067334
(87) Internationale Veröffentlichungsnummer: WO 2015/024836

(56) Entgegenhaltungen:
- WO-A1-2010/043936
- DE-A1-102008 063 366
- DE-A1-102010 049 400
- FR-A1- 2 933 825
- US-A1- 2011 182 458

## Beschreibung

Die Erfindung bezieht sich auf eine Einrichtung zum berührungslosen Betätigen, d.h. zum Öffnen und/oder Schließen einer Fahrzeugtür nach dem Oberbegriff des Anspruchs 1. Der Begriff "Fahrzeugtür" bezeichnet hier und im Folgenden allgemeine beliebige Elemente, mit denen die Außenhaut eines Fahrzeugs geöffnet und geschlossen werden kann, insbesondere auch eine Heckklappe, einen Kofferraumdeckel, ein Schiebedach oder einen Tankdeckel.

Für einen Benutzer eines Fahrzeugs ist es mitunter wünschenswert, eine Fahrzeugtür, insbesondere die Heckklappe eines Kofferraums, berührungslos zu öffnen oder zu schließen. Dies ist zum Beispiel der Fall, wenn der Benutzer beide Hände einsetzt, um einen Gegenstand wie zum Beispiel einen Bierkasten zu tragen, der in den Kofferraum des Fahrzeugs gelegt werden soll.

Eine gattungsgemäße Einrichtung zum berührungslosen Betätigen einer Heccklappe ist beispielsweise aus DE 10 2008 063 366 A1 bekannt. Die bekannte Einrichtung weist zwei kapazitive Näherungssensoren, und somit insbesondere zwei Sensorelektroden auf. Die Sensorelektroden sind hierbei in einem hinteren Bereich bzw. in einem unteren Bereich des hinteren Stoßfängers eines Fahrzeugs angeordnet und detektieren eine Fußbewegung des Benutzers als Türöffnungswunsch, worauf durch die Einrichtung die Öffnung der Heckklappe veranlasst wird. Die Einrichtung ist darauf ausgelegt, die Heckklappe zu öffnen, wenn der Benutzer seinen Fuß unter den Stoßfänger streckt.

Wünschenswerterweise soll eine solche Sensoreinheit in der Lage sein, eine bestimmte charakteristische Fußbewegung, mit der der Türöffnungswunsch angezeigt werden soll, sicher von anderen Fußbewegungen zu unterscheiden. Beispielsweise soll die Sensoreinheit die Kofferraumöffnung veranlassen, wenn der Fahrzeugbenutzer eine Kickbewegung in Fahrzeuglängsrichtung unter den Stoßfänger vollführt, während die Kofferraumöffnung unterbleiben soll, wenn der Fahrzeugnutzer seinen Fuß in anderer Weise (und anderer Absicht) in der Nähe der Sensorelektroden bewegt.
Erfahrungsgemäß ist eine präzise Unterscheidung zwischen der für den Türöffnungswunsch charakteristischen Fußbewegung und anderen Bewegungen allerdings nur dann mit hinreichender Sicherheit möglich, wenn die von den beiden Sensorelektroden jeweils emittierten Detektionsfelder hinreichend getrennt sind. Hierzu müssen die Sensorelektroden - in Abwesenheit von Maßnahmen zur Formung der Detektionsfelder - in genügend großem Abstand von typischerweise mindestens 5 cm zueinander angeordnet werden. Dies ist bauraumbedingt nicht in allen Fahrzeugen möglich.

Zur besseren Formung der Detektionsfelder werden bisweilen, so auch bei der in DE 10 2008 063 366 A1 offenbarten Einrichtung, auf Massepotential gesetzte Abschirmelektroden eingesetzt, die die Sensorelektroden rückseitig (fahrzeugseitig) umgeben und somit elektrisch gegenüber der Fahrzeugkarosserie abschirmen. Nachteiligerweise reduzieren solche Abschirmelektroden allerdings die Empfindlichkeit der Näherungssensoren, da sie eine erhebliche - bewegungsunabhängige - Offsetkapazität erzeugen, die regelmäßig wesentlich größer ist als das eigentliche Messsignal. Zudem verursachen solche Abschirmelektroden und deren Erdung einen nicht unerheblichen schaltungstechnischen Zusatzaufwand.

Das Dokument FR2933825 A1 offenbart einen kapazitiven Berührungssensor mit zwei flächigen Elektroden, die kapazitiv zueinander gekoppelt sind.

Der Erfindung liegt die Aufgabe zugrunde, eine möglichst einfache Einrichtung zum berührungslosen Betätigen einer Fahrzeugtür anzugeben, die hinsichtlich ihrer Fehleranfälligkeit verbessert ist.

Diese Aufgabe wird erfindungsgemäß gelöst durch die Merkmale des Anspruchs 1. Vorteilhafte Ausgestaltungsformen der Erfindung sind in den Unteransprüchen und der nachfolgenden Beschreibung dargelegt.

Danach wird eine Einrichtung zum berührungslosen Betätigen einer Fahrzeugtür eines Fahrzeugs angegeben, die einen kapazitiven Näherungssensor mit mindestens einer Sensorelektrode zur Emission eines elektrischen Detektionsfeldes in einem der Sensorelektrode vorgelagerten Detektionsraum umfasst. Erfindungsgemäß ist der Sensorelektrode ein isolierter elektrischer Leiter zur Formung des Detektionsfeldes vorgeordnet. Als "isolierter" elektrischer Leiter wird dabei ein Körper aus elektrisch leitfähigem Material verstanden, der mit keinem anderen Gegenstand galvanisch verbunden ist, so dass auf diesen Leiter insbesondere keine elektrische Ladung aufgebracht werden kann. Mithin kann an den isolierten Leiter auch kein bestimmtes - von äußeren elektrischen Feldern unabhängiges - elektrisches Potential angelegt werden. Der erfindungsgemäß der Sensorelektrode vorgeordnete Leiter unterscheidet sich hierdurch von einer Elektrode, insbesondere einer geerdeten Abschirmelektrode.

Die mit der Erfindung genutzte Wirkung des isolierten Leiters besteht erkanntermaßen darin, dass der isolierte Leiter in dem elektrischen Detektionsfeld der Sensorelektrode eine Äquipotentialfläche bildet. Durch Ladungsverschiebung im Inneren des Leiters werden die Feldlinien des Detektionsfeldes in der Umgebung des Leiters derart verformt, dass die Feldlinien überall senkrecht auf die Oberfläche des Leiters treffen. Dieser Effekt wird vorteilhaft zur Formung und Ausrichtung des Detektionsfeldes eingesetzt und ermöglicht somit eine hohe Fehlersicherheit der Einrichtung.

Im Gegensatz zu einer Abschirmelektrode bewirkt der Leiter einerseits keine Abschwächung des Detektionsfelds in dem von der Sensorelektrode abgewandten Raumbereich. Vielmehr bewirkt der Leiter durch Konzentration und Homogenisierung des elektrischen Feldes in seiner Umgebung sogar regelmäßig eine lokale Feldverstärkung. Wiederum im Gegensatz zu einer Abschirmelektrode beeinflusst der im Detektionsfeld angeordnete isolierte Leiter andererseits die messbare Kapazität der Sensorelektrode allenfalls geringfügig und beeinträchtigt somit auch nicht die Empfindlichkeit des Näherungssensors.

Schließlich kann die erfindungsgemäße Einrichtung infolge des Einsatzes des isolierten Leiters auch besonders einfach realisiert werden, insbesondere zumal sie bezüglich der Anordnung der Sensorelektroden eine vergleichsweise hohe Flexibilität erlaubt und auch der mit Abschirmelektroden gewöhnlich verbundene Schaltungsaufwand entfällt.

Gemäß der Einrichtung ist der Leiter durch eine flächige Folie oder eine (elektrisch leitfähige) Beschichtung gebildet, die auf einem der Sensorelektrode vorgelagerten (selbst elektrisch isolierenden) Fahrzeugteil aufgebracht oder in ein solches Fahrzeugteil eingebracht ist. Bei Ausbildung als Folie ist der Leiter vorzugsweise auf das Fahrzeugteil aufgeklebt, auflaminiert oder in das Material des Fahrzeugteils eingebettet. Ein Leiter in Form einer Beschichtung kann beispielsweise durch Aufdampfen, Sputtern, Spritzen oder Streichen hergestellt sein. Alternativ zu den vorstehend genannten Ausführungsformen kann der Leiter im Rahmen der Erfindung allerdings auch durch ein massives Metallteil, ein Netz oder Gewebe aus Draht oder eine elektrisch leitfähige Kunststoffschicht gebildet sein.

Besonders vorteilhaft ist der Einsatz des Leiters bei einer Sensorelektrode, die aufgrund ihrer Geometrie selbst das Detektionsfeld nicht in eine ausgeprägte Vorzugsrichtung emittiert. So ist die Sensorelektrode erfindungsgemäß durch einen (im Querschnitt kreisrunden oder ovalen) Rundleiter gebildet, der das Detektionsfeld ohne die feldformende Wirkung des isolierten Leiters in einer zumindest annähernd radialsymmetrischen - und somit wenig gerichteten - Form emittieren würde.

In einer bevorzugten Anwendung handelt es sich bei der zu betätigenden Fahrzeugtür eine Heckklappe. Der isolierte Leiter ist hierbei zweckmäßigerweise auf einer hinteren Stoßfängerverkleidung des Fahrzeugs - insbesondere außenseitig - aufgebracht oder in die hintere Stoßfängerverkleidung eingebracht.

Zur präzisen Unterscheidung der einen Türöffnungswunsch signalisierenden Fußbewegung von anderen Bewegungen im Umfeld der Heckklappe umfasst die Einrichtung zweckmäßigerweise zwei mit gegebenem Abstand übereinander hinter der Stoßfängerverkleidung angebrachte Sensorelektroden, die zur Emission eines oberen Detektionsfeldes bzw. eines unteren Detektionsfeldes in einen jeweils zugeordneten Detektionsraum dienen. Der isolierte Leiter ist dabei insbesondere der oberen Sensorelektrode zugeordnet. Zur räumlichen Trennung der beiden Detektionsfelder ist dieser Leiter - in der bestimmungsgemäßen Einbausituation am Fahrzeug - zumindest näherungsweise auf gleicher Höhe mit der oberen Sensorelektrode oder höher als dieselbe angeordnet. Im Rahmen der Erfindung kann der unteren Sensorelektrode ein weiterer isolierter Leiter zugeordnet sein, um die Detektionsfelder noch besser zu trennen. Durch den oder die Leiter ist zudem auch eine verbesserte Ausrichtung des jeweiligen Detektionsfeldes möglich.

Nachfolgend wird ein Ausführungsbeispiel der Erfindung anhand einer Zeichnung näher erläutert. Darin zeigen:
- Fig. 1: in einer grob schematischen Seitenansicht ein Heckteil eines Kraftfahrzeugs, mit einer Heckklappe und einer Einrichtung zur berührungslosen Betätigung derselben, sowie
- Fig. 2: eine vergrößerte Detailansicht II aus Fig. 1.

Einander entsprechende Teile und Größen sind in allen Figuren stets mit den gleichen Bezugszeichen versehen.

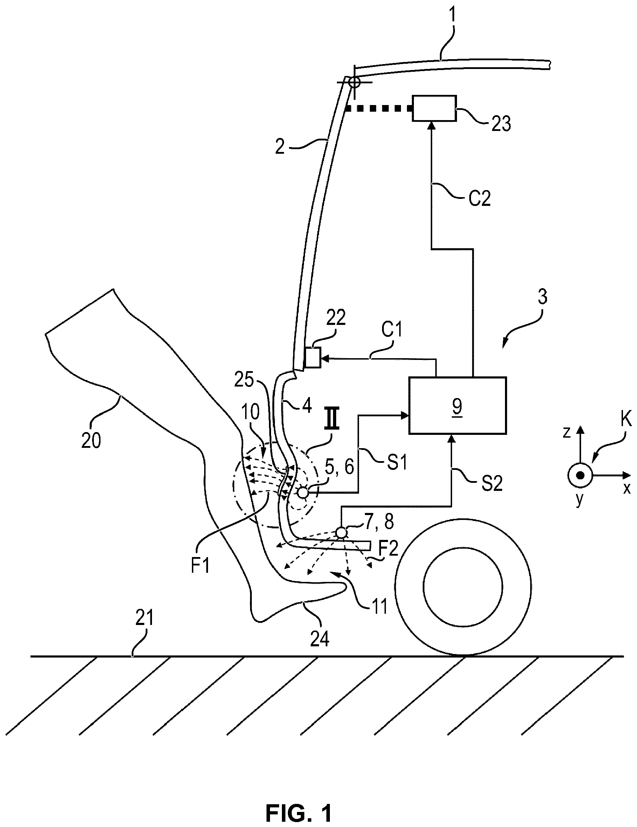

Fig. 1 zeigt einen heckseitigen (hinteren) Abschnitt eines Kraftfahrzeugs 1, mit einer Heckklappe 2 sowie mit einer Einrichtung 3 zum berührungslosen Betätigen derselben. Das Kraftfahrzeug 1 umfasst weiterhin einen heckseitigen Stoßfänger mit einer Stoßfängerverkleidung 4 aus Kunststoff.

Bezüglich des Fahrzeugs 1 ist ein kartesisches Fahrzeugkoordinatensystem K definiert. In diesem Fahrzeugkoordinatensystem K sind die in Fahrtrichtung zeigende Fahrzeuglängsachse mit x, die hierzu senkrechte horizontale Fahrzeugquerachse mit y (senkrecht zur Zeichenebene der Fig. 1) und die vertikal nach oben zeigende Hochachse mit z bezeichnet.

Die Einrichtung 3 umfasst einen ersten kapazitiven Näherungssensor 5 mit einer Sensorelektrode 6 sowie einen zweiten kapazitiven Näherungssensor 7 mit einer Sensorelektrode 8. Beide Sensorelektroden 6 und 8 sind als Rundleiter, z.B. jeweils als draht- oder zylindermantelförmiger elektrischer Leiter ausgebildet. Die beiden Näherungssensoren 5 und 7 können als voneinander unabhängige Baueinheiten ausgebildet sein. In bevorzugter Ausführung teilen sich beide Näherungssensoren 5 und 7 aber eine gemeinsame (nicht explizit dargestellte) Kapazitätsmessschaltung, mit der die beiden Sensorelektroden 6 und 8 verschaltet sind.

Die Einrichtung 3 umfasst außerdem eine Steuereinheit 9, die im Wesentlichen durch einen Mikrocontroller mit einer darin implementierten Steuersoftware gebildet ist.

Die beiden Sensorelektroden 6,8 sind an einer Innenseite der Stoßfängerverkleidung 4 angebracht. Die Sensorelektroden 6 und 8 sind dabei in einem hinteren Bereich bzw. einem unteren Bereich der Stoßfängerverkleidung 4 angebracht.

Die Sensorelektrode 6 ist hierdurch höher angeordnet als die Sensorelektrode 8, weshalb die Sensorelektrode 6 auch als "obere Sensorelektrode" und die Sensorelektrode 8 auch als "untere Sensorelektrode" bezeichnet sind. Der zwischen den Sensorelektroden 6,8 gebildete Abstand beträgt insbesondere weniger als 5 cm.

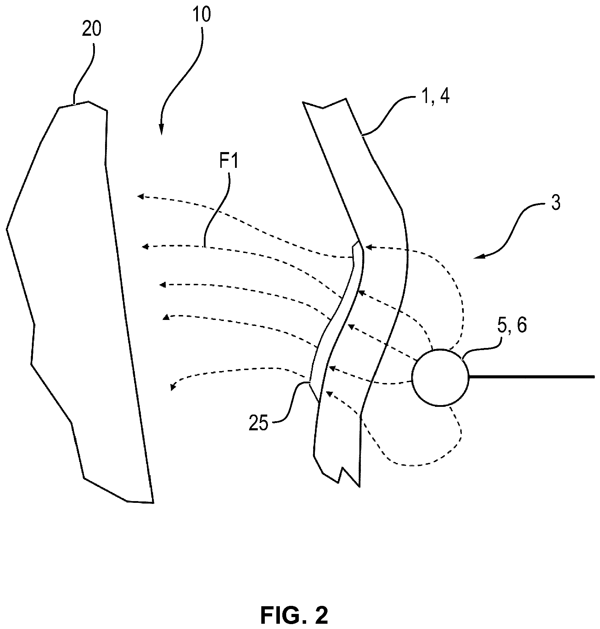

Im Betrieb wird an die Sensorelektroden 6 und 8 jeweils ein elektrisches Messsignal in Form einer elektrischen Wechselspannung angelegt. Unter Wirkung dieses Messsignals bildet sich in einem der oberen Sensorelektrode 6 vorgelagerten Raumvolumen, das nachfolgend als "oberer" Detektionsraum 10 bezeichnet ist, ein (oberes) elektrisches Detektionsfeld F1 aus, das in den Fig. 1 und 2 durch Feldlinien schematisch angedeutet ist. Ebenso breitet sich unter Wirkung des elektrischen Messsignals in einem der Sensorelektrode 8 vorgelagerten Raumvolumen (nachfolgend als unterer Detektionsraum 11 bezeichnet) ein unteres elektrisches Detektionsfeld F2 aus, das in Fig. 1 ebenfalls durch Feldlinien schematisch angedeutet ist.

Ein in dem jeweiligen Detektionsraum 10,11 eingebrachtes menschliches Körperteil - gemäß Fig. 1 beispielhaft ein Bein 20 eines Fahrzeugnutzers - wirkt aufgrund der elektrischen Leitfähigkeit des menschlichen Körpergewebes und der Erdung des Körpergewebes mit dem Untergrund 21 als Gegenelektrode zu der jeweiligen Sensorelektrode 6,8. Jede der Sensorelektroden 6 und 8 bildet somit mit dem Bein 20 einen (elektrischen) Kondensator, dessen Kapazität sich mit dem Abstand des Beins 20 zu der jeweiligen Sensorelektrode 6,8 in charakteristischer Weise ändert.

Um einen Türöffnungswunsch des Fahrzeugnutzers zu erkennen, erfasst die Steuereinheit 9 Signale S1 und S2 der Näherungssensoren 5 bzw. 7, die eine Information über die von dem jeweiligen Näherungssensor 5,7 erfasste Kapazität, und somit eine Information über die Anwesenheit eines Körperteils in den jeweiligen Detektionsraum 10 oder 11 beinhalten. Die Signale S1 und S2 werden von der Steuereinheit 9 nach Maßgabe hinterlegter Kriterien dahingehend ausgewertet, ob eine bestimmte, zur Signalisierung eines Türöffnungswunsches festgelegte Beinbewegung des Fahrzeugnutzers erkannt werden kann. Ggf. steuert die Steuereinheit 9 durch Stellsignale C1 und C2 ein der Heckklappe 2 zugeordnetes Türschloss 22 bzw. einen elektrischen Stellmotor 23 einer Heckklappenstellvorrichtung an, so dass die Heckklappe 2 durch den Stellmotor 23 automatisch geöffnet wird. Als charakteristische Körperbewegung zur Signalisierung eines Türöffnungswunsches ist beispielsweise eine Kickbewegung festgelegt, bei der der Fahrzeugnutzer den Fuß 24 kurzzeitig in der in Fig. 1 dargestellten Weise unter die Stoßfängerverkleidung 4 streckt und anschließend zurückzieht. Diese Beinbewegung äußerst sich in charakteristischer Weise in einem pulsartigen, synchronen Signalverlauf beider Messsignals S1 und S2, der von der Steuereinheit 9 durch vergleichende Auswertung beider Messsignale S1 und S2 als Hinweis auf den Türöffnungswunsch erkannt wird.

Eine hinreichende sichere Unterscheidung der für den Türöffnungswunsch festgelegten Kickbewegung von anderen Beinbewegungen, die der Fahrzeugnutzer in anderer Absicht vollzieht, ist allerdings nur dann durch die von der Steuereinheit 9 vorgenommene Signalanalyse möglich, wenn die Detektionsfelder F1 und F2 hinreichend voneinander räumlich separiert sind. Diese Separierung der Detektionsfelder F1 und F2 wird im Rahmen der Einrichtung 3 durch einen isolierten (und somit von der Umgebung vollständig galvanisch getrennten elektrischen Leiter 25 unterstützt, der der Sensorelektrode 6 in Richtung auf den zugeordneten Detektionsraum 10 vorgelagert ist. Der in den Fig. 1 und 2 nur grob schematisch dargestellte Leiter 25 ist vorzugsweise durch eine Metallfolie gebildet, die außenseitig mit der Stoßfängerverkleidung 4 verklebt ist. In einer alternativen Ausgestaltung ist der Leiter 25 durch eine metallische Beschichtung gebildet, die auf die Stoßfängerverkleidung 4 durch Bedampfen oder Spritzen aufgebracht ist. Wie in den Figuren grob schematisch angedeutet ist, bewirkt der Leiter 25 eine Umformung des Verlaufs des elektrischen Feldes F1, das von der Sensorelektrode 6 in Abwesenheit des Leiters 25 in zumindest näherungsweise radialsymmetrischer Form emittiert werden würde. Wie in den Fig. 1 und 2 erkennbar ist, ist der Leiter 25 (in Richtung der Hochachse z) geringfügig höher angeordnet als die Sensorelektrode 6 und lenkt somit deren Detektionsfeld F1 nach oben ab.

### Bezugszeichenliste

- 1: Kraftfahrzeug
- 2: Heckklappe
- 3: Einrichtung
- 4: Stoßfängerverkleidung
- 5: Näherungssensor
- 6: Sensorelektrode
- 7: Näherungssensor
- 8: Sensorelektrode
- 9: Steuereinheit
- 10: (oberer) Detektionsraum
- 11: (unterer) Detektionsraum
- 20: Bein
- 21: Untergrund
- 22: Türschloss
- 23: Stellmotor
- 24: Fuß
- 25: Leiter

- K: Fahrzeugkoordinatensystem
- x: Fahrzeuglängsachse
- y: Fahrzeugquerachse
- z: Hochachse
- F1: (oberes) Detektionsfeld
- F2: (unteres) Detektionsfeld
- S1: Signal
- S2: Signal
- C1: Stellsignal
- C2: Stellsignal

## Patentansprüche

1. Einrichtung (3) zum berührungslosen Betätigen einer Fahrzeugtür (2) eines Fahrzeugs (1), mit einem kapazitiven Näherungssensor (5), der mindestens eine Sensorelektrode (6) zur Emission eines elektrischen Detektionsfeldes (F1) in einem der Sensorelektrode (6) vorgelagerten Detektionsraum (10) aufweist,wobei der Sensorelektrode (6) ein isolierter elektrischer Leiter (25) zur Formung des Detektionsfeldes (F1) vorgeordnet ist, wobei der Leiter (25) durch eine flächige Folie oder Beschlchtung gebildet ist, die auf einem der Sensorelektrode (6) vorgelagerten Fahrzeugteil (4) aufgebracht oder in ein solches Fahrzeugteil (4) eingebracht ist und wobei die Sensorelektrode (6) durch einen Rundleiter gebildet ist.

2. Einrichtung (3) nach Anspruch 1,
wobei die zu betätigende Fahrzeugtür eine Heckklappe (2) ist, und wobei der Leiter (25) auf einer hinteren Stoßfängerverkleidung (4) des Fahrzeugs (1) aufgebracht oder in die hintere Stoßfängerverkleidung (4) eingebracht ist.

3. Einrichtung (3) nach Anspruch 1,
mit zwei mit gegebenem Abstand übereinander hinter der Stoßfängerverkleidung (4) angebrachten Sensorelektroden (6,8), die zur Emission eines oberen Detektionsfeldes (F1) bzw. eines unteren Detektionsfeldes (F2) in einen jeweils zugeordneten Detektionsraum (10;11) dienen, wobei der Leiter (25) der oberen Sensorelektrode (6) zugeordnet und zur räumlichen Trennung der beiden Detektionsfelder (F1;F2) zumindest näherungsweise auf gleicher Höhe mit der oberen Sensorelektrode (6) oder höher als dieselbe angeordnet ist.

## Claims

1. Arrangment (3) for the contactless actuation of a vehicle door (2) of a vehicle (1), with a capacitive proximity sensor (5) which comprises at least one sensor electrode (6) for the emission of an electrical detection field (F1) in a detection space (10) disposed upstream of the sensor electrode (6), wherein an insulated electrical conductor (25) for forming the detection field (F1) is arranged upstream of the sensor electrode (6), said conductor (25) being formed by a flat film or coating which is applied to a vehicle part (4) disposed upstream of the sensor electrode (6) or is inserted into such a vehicle part (4), and the sensor electrode (6) being formed by a circular conductor.

2. Arrangement (3) according to Claim 1,
wherein the vehicle door to be actuated is a tailgate (2), and wherein the conductor (25) is mounted on a rear bumper trim (4) of the vehicle (1) or is inserted into the rear bumper trim (4).

3. Arrangement (3) according to Claim 1,
with two sensor electrodes (6, 8) mounted at a given distance one above the other behind the bumper trim (4), which serve for emitting an upper detection field (F1) and a lower detection field (F2), respectively, into a respectively associated detection space (10; 11), wherein the conductor (25) is associated with the upper sensor electrode (6) and arranged at least approximately at the same height as the upper sensor electrode (6) or higher than said upper sensor electrode for spatial separation of the two detection fields (F1; F2).

## Revendications

1. Arrangement (3) pour l'actionnement sans contact d'une porte de véhicule (2) d'un véhicule (1), avec un capteur de proximité capacitif (5) qui a au moins une électrode de détection (6) pour l'émission d'un champ de détection électrique (F1) dans une espace de détection (10) disposée en amont de l'électrode de détection (6), dans lequel un conducteur électrique isolé est arrangé en amont de l'électrode de détection (6) pour former le champ de détection (F1), ledit conducteur (25) étant formé par un film ou un revêtement de forme plane qui est appliqué sur une partie de véhicule (4) disposée en amont de l'électrode de détection (6) ou qui est introduit dans une telle partie de véhicule (4), et l'électrode de détection (6) étant formée par un conducteur rond.

2. Arrangement (3) selon la revendication 1,
dans lequel la porte du véhicule à actionner est un hayon (2), et dans lequel le conducteur (25) est monté sur une garniture de pare-chocs arrière (4) du véhicule (1) ou est introduit dans la garniture de pare-chocs arrière (4).

3. Arrangement (3) selon la revendication 1,
avec deux électrodes de détection (6, 8) montées à une distance donnée l'une au-dessus de l'autre derrière la garniture du pare-chocs (4), qui sont destinées pour l'émission d'un champ de détection supérieur (F1) ou un champ de détection inférieur (F2), respectivement, dans une espace de détection respectivement associée (10 ; 11), le conducteur (25) étant associé à l'électrode de détection supérieure (6) et étant disposé au moins approximativement à la même hauteur que l'électrode de détection supérieure (6) ou plus haut que celle-ci pour la séparation spatiale des deux champs de détection (F1 ; F2).
